# EUROPEAN PATENT SPECIFICATION

(11) **EP 2 986 682 B1**
(45) Date of publication and mention of the grant of the patent: **20.10.2021**
(21) Application number: 14784770.1
(22) Date of filing: 17.02.2014
(51) Int. Cl.: C09D 11/52, H01B 1/22, C09D 11/102, H01L 31/02

(54) **ELECTRICALLY CONDUCTIVE INKS**
ELEKTRISCH LEITFÄHIGE TINTEN
ENCRES ÉLECTROCONDUCTRICES

(30) Priority: 17.04.2013 WO PCT/CN2013/074294; 12.12.2013 WO PCT/CN2013/089199
(43) Date of publication of application: 24.02.2016
(73) Proprietor: Henkel AG & Co. KGaA, 40589 Düsseldorf (DE)
(72) Inventor: WU, Kily, Shanghai 200131 (CN); HENCKENS, Anja, 3520 Zonhoven B-3520 (BE)
(86) International application number: PCT/CN2014/072149
(87) International publication number: WO 2014/169728

(56) References cited:
- WO-A1-2012/063747
- CN-A- 102 746 741
- JP-A- 2007 131 950
- JP-A- 2009 209 347
- JP-A- 2011 195 695
- US-A- 4 542 258
- US-A- 5 045 141
- US-A1- 2005 270 620
- US-A1- 2012 119 163
- None

## Description

The present invention relates to compositions that are suitable for use as electrically conductive inks in the fabrication of electronic devices, such as c-Si solar modules. The electrically conductive ink comprises a) from 8 to 12 wt% based on the total amount of the electrically conductive ink of one or more aromatic resins; b) from 52 to 68 wt% based on the total amount of the electrically conductive ink of electrically conductive silver particles, wherein the electrically conductive silver particles have a silver content of at least 95 wt.-%, based on the total amount of the electrically conductive silver particles, having an average particle size of 2 µm to 20 µm, and a tap density of 2.5 g/cm³ to 6.0 g/cm³ and c) from 15 to 35 wt% based on the total amount of the electrically conductive ink of one or more organic solvents, when the electrically conductive ink only comprises aromatic resins and no further non-aromatic resins. The present invention further relates to a method of forming an electrically conductive pathway on a substrate and to a method of forming a bonded assembly using said electrically conductive ink.

Many different forms of electronic devices employ printed circuit boards having electrically conductive inks. Electrically conductive inks are screen printable and are used to form conductive elements in electronic applications. For example, conductive inks are utilized as screen-printed electronic circuitry in through hole connection, jumpers, printed board wiring and similar electronic applications to provide stable electrical interconnections.

JP2009-209347 discloses an electrically-conductive ink comprising a conductive substance, which is a flaky silver particles having a particle size from 1 to 15µm and specific surface area of 0.3-4 m²/g and a phenoxy and rosin based binder component.

JP2011-195695 discloses an electroconductive composition, which contains: (1) polyaniline synthesized by oxidative polymerization of aniline in the presence of a petroleum solvent, an aqueous solution of phosphoric acid, and a surfactant containing a sulfonic acid group; (2) electroconductive fine particles; and (3) a compound including a phenolic hydroxy group, wherein the aqueous solution of phosphoric acid has pH of 2-5, and the polyaniline has a weight-average molecular weight of 30,000-60,000.

US4542258 discloses a solar cell assembly including: a solar cell having a surface with an electrically conductive pattern disposed thereon; at least one bus bar disposed adjacent to said conductive pattern; and means for attaching said bus bar to said solar cell including at least one segment of adhesive material disposed between said bus bar and said surface of said solar cell and a dip-soldered electrical and physical connection formed between said bus bar and said conductive pattern adjacent said adhesive material.

WO2012/063747 discloses a conductive composition comprising the metal particles, which are a non-nucleated, spherical porous material having continuous open pores, and a resin.

There are many drawbacks to currently available electrically conductive inks. One such drawback is that many conductive inks have an insufficient adhesion to some metallic surfaces, such as aluminum. A further drawback of electrically conductive inks is that these materials often do not form a stable and reliable electrical interconnection after being soldered to a further metallic substrate, such as a connection strap, like normal Sn alloy ribbons.

Consequently, it would be advantageous to develop an electrically conductive ink which would exhibit a good adhesion to various metallic substrates, such as aluminum or aluminum-containing substrates. It would further be advantageous to provide an electrically conductive ink which can be soldered directly to further metallic substrate, thereby forming a stable and reliable electrical interconnection having a good bonding strength.

### Short description of figures

Figure 1 is a cross section SEM of C1 after soldering; before the peel (left) and after the peel (right).
Figure 2 is a cross section SEM of C7 after soldering; before the peel (left) and after the peel (right).
Figure 3 is a cross section SEM of C11 after soldering; before the peel (left) and after the peel (right).
Figure 4 is a cross section SEM of C15 after soldering; before the peel (left) and after the peel (right).
Figure 5 is a cross section SEM of D1 after soldering; before the peel (left) and after the peel (right).
Figure 6 is a cross section SEM of D5 after soldering; before the peel (left) and after the peel (right).

The present invention provides an electrically conductive ink having an excellent adhesion to aluminum or aluminum-containing substrates. After having been dried said electrically conductive ink can be soldered directly to further metallic substrates, wherein a stable and reliable electrical interconnection is formed which exhibits a good bonding strength.

The electrically conductive ink, comprising a) from 8 to 12 wt% based on the total amount of the electrically conductive ink of one or more aromatic resins; b) from 52 to 68 wt% based on the total amount of the electrically conductive ink of electrically conductive silver particles, wherein the electrically conductive silver particles have a silver content of at least 95 wt.-%, based on the total amount of the electrically conductive silver particles, having an average particle size of 2 µm to 20 µm, wherein D₅₀ value is measured through laser diffractometry, and a tap density of 2.5 g/cm³ to 6.0 g/cm³, wherein the tap density is determined in accordance to ISO 3953 typically using a 25 cm³ graduated glass cylinder; and c) from 15 to 35 wt% based on the total amount of the electrically conductive ink of one or more organic solvents, when the electrically conductive ink only comprises aromatic resins and no further non-aromatic resins.

The term "aromatic resin", as used herein, refers to oligomeric or polymeric materials comprising at least one aromatic group as part of their molecular structure. Suitable aromatic groups include phenylene groups, phenyl groups, or polycyclic aromatic groups. Preferred aromatic resins exhibit an amount of aromatic groups, based on the total amount of the resin, of at least 5 wt.-%, more preferably of at least 10 wt.-%, and particularly preferably of at least 15 wt.-%.

The use of aromatic resins in the electrically conductive inks is essential for the present invention, because a sufficient adhesion to various metallic substrates, such as aluminum or aluminum-containing substrates is only achieved, when resins are employed which comprise at least one aromatic group as part of their molecular structure.

The aromatic resin component acts as a film forming agent and/or binder material. Suitable aromatic resins may be selected from the group consisting of phenoxy resins, aromatic polyester resins, aromatic thermoplastic polyurethanes, and any combination thereof.

Phenoxy resins are particularly suitable for use in the present invention. As used herein the term "phenoxy resin" refers to oligomeric or polymeric poly(hydroxyethers) derived from the reaction of polyphenols, such as bisphenols and epichlorohydrin. The use of phenoxy resin is advantageous because these resins have a very good thermal stability, exhibit an excellent resistance to oxygen and moisture, and do not decompose in the presence of acid or basic materials.

Suitable phenoxy resins for use in the present invention can be prepared by admixing from 0.98 to 1.02 moles of epichlorohydrin with one mole of a dihydric phenol together with from 0.6 to 1.5 moles of an alkali metal hydroxide, such as, sodium hydroxide or potassium hydroxide, generally in an aqueous medium, at a temperature of 0°C to 50°C until at least 60 mole percent of the epichlorhydrin has been consumed. To further improve the bonding strength on various metallic surfaces it may be desirable to modify the phenoxy resins by grafting thereon moieties containing pendant carboxyl groups. These carboxylic acid-grafted phenoxy resins can be prepared, for example, by reacting one or more phenoxy resins with one or more monoanhydrides of di- or polycarboxylic acids.

Preferred phenoxy resins have a weight average molecular weight (M_{w}) from 10000 g/mol to 70000 g/mol, more preferably from 20000 g/mol to 55000 g/mol. In the present invention the weight average molecular weight (M_{w}) is determined by gel permeation chromatography (GPC) preferably using a polystyrene standard.

Of course, combinations of different phenoxy resins are also desirable for use herein.

Commercially available phenoxy resins suitable for use in the present invention include Phenoxy PKHH, a trade designation of InChem Corp. for a condensation polymer derived from bisphenol-A (2,2-bis(p-hydroxyphenyl)propane and epichlorohydrin.

In an embodiment the total amount of all aromatic resins present in the electrically conductive ink of the present invention is in the range of 8 to 12 wt.-%, each based on the total amount of the electrically conductive ink of the present invention.

In a further embodiment the total amount of all phenoxy resins present in the electrically conductive ink of the present invention is in the range of 8 to 12 wt.-%, each based on the total amount of the electrically conductive ink of the present invention.

A particular good adhesion on various metallic surfaces in combination with a good solderability is achieved, when the electrically conductive ink only comprises aromatic resins and no further non-aromatic resins.

The electrically conductive ink of the present invention further comprises electrically conductive silver particles having an average particle size of 2 µm to 20 µm, and a tap density of 2.0 g/cm³ to 6.0 g/cm³.

The term "electrically conductive silver particles", as used herein, refers to particles mainly consisting of silver (Ag). The electrically conductive silver particles have a silver content of at least 95 wt.-%, more preferably of at least 98 wt.-%, and particularly preferably of at least 99 wt.-%, each based on the total amount of the electrically conductive silver particles. Nevertheless it may be possible that said silver particles comprise small amounts of other metals as impurities.

As used in the present invention, the term "average particle size" refers to the D₅₀ value of the cumulative volume distribution curve at which 50% by volume of the particles have a diameter less than said value. The volume average particle size or D₅₀ value is measured in the present invention through laser diffractometry, preferably using a Malvern Mastersizer 2000 available from Malvern Instruments Ltd. In this technique, the size of particles in suspensions or emulsions is measured using the diffraction of a laser beam, based on application of either Fraunhofer or Mie theory. In the present invention, Mie theory or a modified Mie theory for non-spherical particles is applied and the average particle sizes or D₅₀ values relate to scattering measurements at an angle from 0.02 to 135 degrees relative to the incident laser beam. For the measurement it is further on preferred that a dispersion of the particles in a suitable liquid, such as acetone, is prepared by using ultrasonication. In order to produce an acceptable signal-to-noise ratio the particle concentration in the dispersion should preferably be chosen in a way that an obscuration between 6% and 20% is obtained.

The tap density is determined in accordance to ISO 3953 typically using a 25 cm³ graduated glass cylinder. The principle of the method specified is tapping a specified amount of powder in a container by means of a tapping apparatus until no further decrease in the volume of the powder takes place. The mass of the powder divided by its volume after the test gives its tap density.

Electrically conductive silver particles having a tap density of less than 1.5 g/cm³ are unsuitable for use in the present invention because the resulting soldering strength is insufficient after the electrically conductive ink has been dried and soldered to a further metallic surface. Electrically conductive silver particles having a tap density of more than 6.5 g/cm³ significantly reduce the processability of the corresponding inks which render these materials unsuitable for use in standard industrial applications.

Preferred electrically conductive silver particles have an average particle size of 2 µm to 20 µm, and more preferably of 3 µm to 10 µm. The preferred tap density of the electrically conductive silver particles is from 2.5 g/cm³ to 6.0 g/cm³, and more preferably from 3.5 g/cm³ to 5.5 g/cm³.

A particularly good adhesion and solderability is obtained when electrically conductive silver particles are used which have an average particle size of 2 µm to 20 µm and a tap density of 2.5 g/cm³ to 6.0 g/cm³. More preferably electrically conductive silver particles are used which have an average particle size of 3 µm to 10 µm and a tap density of 3.5 g/cm³ to 5.5 g/cm³.

To further improve the solderability of the electrically conductive ink of the present invention it is desirable that the electrically conductive silver particles have a specific surface area of 0.1 m²/g to 1.6 m²/g. The preferred specific surface area of the electrically conductive silver particles is from 0.2 m²/g to 1.2 m²/g, and more preferably from 0.3 m²/g to 0.8 m²/g.

The term "specific surface area" as used herein refers to the BET specific surface area which is determined in accordance to ASTM B922-10 widely using nitrogen as an analysis gas.

Electrically conductive silver particles having a specific surface area of more than 1.6 m²/g are not preferred for use in the present invention because the resulting soldering strength is often insufficient after the electrically conductive ink has been dried and soldered to a further metallic surface. Electrically conductive silver particles having a specific surface area of less than 0.1 m²/g can significantly reduce the processability of the corresponding inks which render these materials unsuitable for use in standard industrial applications.

Preferred electrically conductive silver particles have an average particle size of 2 µm to 20 µm, a tap density of 2.5 g/cm³ to 6.0 g/cm³, and a specific surface area of 0.2 m²/g to 1.2 m²/g. Electrically conductive silver particles having an average particle size of 3 µm to 10 µm, a tap density of 3.5 g/cm³ to 5.5 g/cm³, and a specific surface area of 0.3 m²/g to 0.8 m²/g are particularly preferably used in the electrically conductive ink of the present invention.

Of course, combinations of different electrically conductive silver particles are also desirable for use herein.

The electrically conductive silver particles according to the invention may be present in the electrically conductive ink in an amount of 52 to 68 wt.-%, each based on the total amount of the electrically conductive ink.

Suitable electrically conductive silver particles are presently available commercially from several companies, such as Metalor Technologies, Ferro Corp., Technic Inc., Eckart GmbH, Ames Goldsmith Corp., Potters Industries Inc., Dowa Holdings Co., Ltd., Mitsui and Fukuda.

As mentioned above, the present invention is to address the drawbacks of conventional conductive ink materials, by presenting conductive ink compositions that can be easily soldered after drying and provide good adhesion to various metallic substrates, such as aluminum or aluminum-containing substrates. For industry interconnection applications, peel strength is a straight forward way to tell both the adhesion of ink to target substrates and soldering strength of ink to a second bonding solder material. Good peel strength indicates good adhesion and good soldering strength. Therefore, good peel strength is required by many industry interconnection applications. One example is interconnection of solar cells into modules. Module manufacturers require good peel strength of soldered ribbons to cells, which would be essential for module reliability and facilitate transportation of interconnected cell strings.

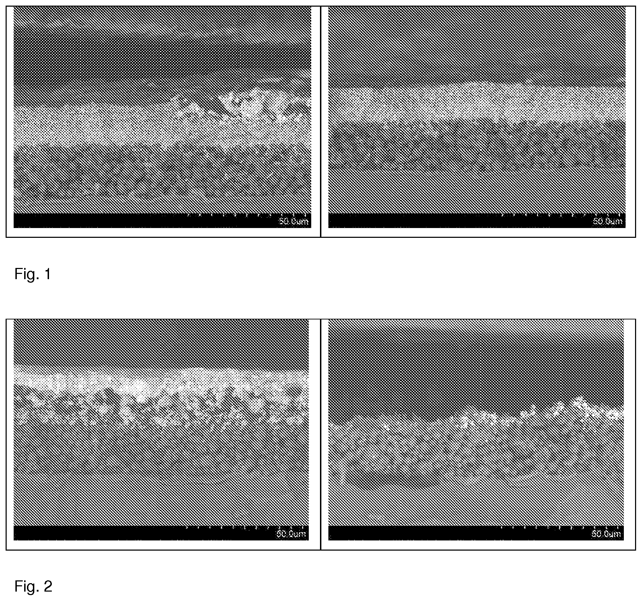

According to the present invention, it was found that the penetration of SnPb (solder) into the ink layer is one of the critical factors for a good peel. Therefore, the filler has preferably compatible morphology for compatible packing in the ink, which is not too dense for melted SnPb to penetrate during the soldering process. This can be seen in figures 1 and 2.

In figures 1 and 2, and following figures, cross section scanning electron microscope (SEM) pictures with x1000 magnification are presented for final formulations. Sample cross section was achieved by extremely low temperature fracture of sample in liquid nitrogen. Therefore, very clear-cut cross section morphology was obtained. SEM pictures were obtained from Hitachi S-3400N under BSE mode with 10-20kV accelerating voltage. A Horiba EDX set was attached to S-3400N to provide elemental analysis of designated area of interest.

In figure 1, the Ag filler used in formulation C1 resulted in very dense packing in dry film. This led to very little penetration of SnPb into the ink layer during soldering, which in turn resulted in very low peel (average 0.16N) and peeling failure at top surface of ink. As a comparison in figure 2, formulation C7 has loose packing, which facilitates SnPb penetration and resulted in very good peel (average 1.72N) and peeling failure in dept of ink layer, i.e. cohesive failure mode.

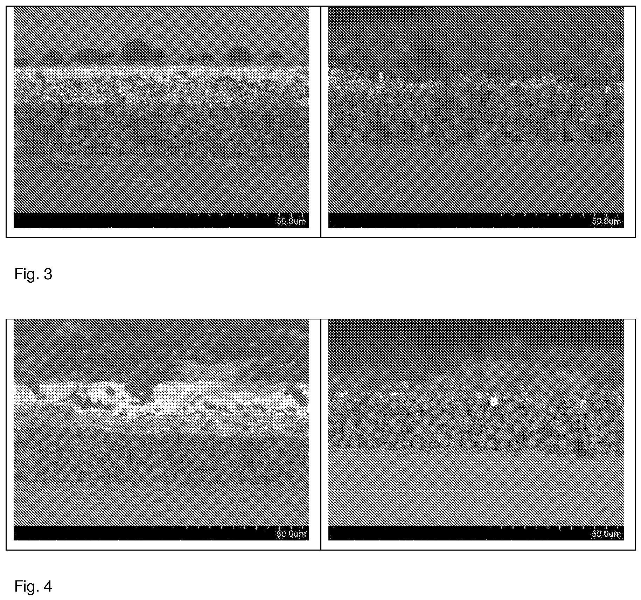

Another critical factor for a good peel is the interfacial bonding between the ink layer and Al layer. Therefore, the filler must have compatible morphology with morphology of fired Al. Lower the compatibility, lower the peel strength. This can be seen in figures 3 and 4.

Neither small Ag flake used in C11 nor large Ag flake used in C15 resulted in dense filler packing in dry film (figures 3 and 4). Thus, both showed good SnPb penetration (figures 3 and 4). However, small flakes in C11 have a morphology that matches surface roughness of fired Al better compared to large flakes in C15 (especially with high aspect ratio). This difference in morphology compatibility between Ag filler and fired Al at the interface led to a good peel (average 1.24N) and cohesive failure mode for C11, while poor peel (average 0.08N) and interfacial failure for C15.

The electrically conductive ink of the present invention may further comprise additional electrically conductive particles, such as metal particles, metal plated particles or metal alloy particles which are substantially free of silver or only partially consist of silver. These particles may comprise other metals, such as platinum, palladium, gold, tin, indium, nickel, copper, aluminum or bismuth and/or combinations thereof. Suitable examples include silver coated copper particles, silver coated boron nitride particles, silver coated aluminum particles, and silver coated glass. Other examples include particles which comprise or consist of carbon black, carbon fibers, or graphite, such as silver coated carbon and silver coated graphite. For the non-silver conductive metal particles or partially silver-containing silver coated particles or silver alloy particles, the applicable average particle size will conventionally be in the range of 1µm to 40µm; the desirable tap density and specific surface area of these particles might differ - for instance, from the above defined tap density and specific surface area of the electrically conductive silver particles - due to different densities of non-silver materials used.

The electrically conductive ink of the present invention further comprises one or more organic solvents. Organic solvents are utilized to substantially dissolve the aromatic resin and to adjust the viscosity of the electrically conductive ink. Solvents which may be utilized include esters, ethers, ether-esters, ketones or combinations thereof. Exemplary organic solvents include amyl acetate, ethyl 3-ethoxypropionate, diethyl glycol, monoethyl ether, diethylene glycol dimethylene ether, acetone, methyl ethyl ketone, cyclohexanone, diethylene glycol monoethyl ether acetate, diethylene glycol monobutyl ether acetate, dipropylene glycol monomethyl ether, dipropylene glycol dimethyl ether, and the like.

Particular good properties and bonding strengths are achieved when the organic solvent of the electrically conductive adhesive is a glycol ether acetate, such as Carbitol acetate.

The electrically conductive ink preferably comprises the organic solvent(s) in a total amount of 15 to 35 wt.-%, each based on the total amount of the electrically conductive ink.

To further optimize its properties the electrically conductive ink of the present invention may further comprise one or more additives, such as flow additives, rheology modifiers, plasticizers, oils, stabilizers, antioxidants, anti-corrosion agents, chelating agents, pigments, dyestuffs, polymeric additives, defoamers, preservatives, thickeners, humectants, adhesion promoters, dispersing agents or any combination thereof.

When used, additives are used in an amount sufficient to provide the desired properties. One or more additives may be present in the inventive electrically conductive ink in an amount in the range of 0.05 to 20 wt.-%, preferably in an amount in the range of 1 to 10 wt.-%, more preferably in an amount in the range of 0.1 wt.-% to 5 wt.-%, more preferably in an amount in the range of 0.2 wt.-% to 5 wt.-% and even more preferably in an amount in the range of 0.2 wt.-% to 2 wt.-%, each based on the total amount of the electrically conductive ink.

One typical formulation of the electrically conductive ink of the present invention comprises or consists of, based on the total amount of said ink:
a) from 8 to 12 wt.-% of one or more aromatic resins;
b) from 52 wt.-% to 68 wt.-% of electrically conductive silver particles having an average particle size of 2 µm to 20 µm, and a tap density of 2.0 g/cm³ to 6.0 g/cm³;
c) from 15 to 35 wt.-% of one or more organic solvents, and
d) from 0 to 20 wt.-% of one or more additives.

Another typical formulation of the electrically conductive ink of the present invention comprises or consists of, based on the total amount of said ink:
a) from 8 to 12 wt.-% of one or more phenoxy resins;
b) from 52 wt.-% to 68wt.-% of electrically conductive silver particles having an average particle size of 2 µm to 20 µm, and a tap density of 2.0 g/cm³ to 6.0 g/cm³;
c) from 15 to 35wt.-% of one or more organic solvents, and
d) from 0 to 20 wt.-% of one or more additives.

A further typical formulation of the electrically conductive ink of the present invention comprises or consists of, based on the total amount of said ink:
a) from 8 to 12 wt.-% of one or more phenoxy resins;
b) from 52wt.-% to 68wt.-% of electrically conductive silver particles having an average particle size of 2 µm to 20 µm, a tap density of 2.0 g/cm³ to 6.0 g/cm³, and a specific surface area of 0.1 m²/g to 1.6 m²/g;
c) from 15 to 35 wt.-% of one or more organic solvents, and
d) from 0 to 20 wt.-% of one or more additives.

A further typical formulation of the electrically conductive ink of the present invention comprises or consists of, based on the total amount of said ink:
a) from 8 to 12 wt.-% of one or more phenoxy resins;
b) from 52 wt.-% to 68 wt.-% of electrically conductive silver particles having an average particle size of 2 µm to 20 µm, a tap density of 2.5 g/cm³ to 6.0 g/cm³, and a specific surface area of 0.2 m²/g to 1.2 m²/g;
c) from 15 to 35 wt.-% of one or more organic solvents, and
d) from 0 to 10 wt.-% of one or more additives.

A further typical formulation of the electrically conductive ink of the present invention comprises or consists of, based on the total amount of said ink:
a) from 8 to 12 wt.-% of one or more phenoxy resins;
b) from 52 wt.-% to 68 wt.-% of electrically conductive silver particles having an average particle size of 2 µm to 20 µm, a tap density of 2.5 g/cm³ to 6.0 g/cm³, and a specific surface area of 0.2 m²/g to 1.2 m²/g;
c) from 15 to 35 wt.-% of one or more organic solvents, and
d) from 0 to 5 wt.-% of one or more additives.

The electrically conductive ink of the present invention can be applied by any technique known in the art, including screen printing. By exposing said ink to an appropriate temperature, such as to a temperature of 70°C to 300°C, the organic solvent is evaporated and the electrically conductive ink is dried. Typically, the electrically conductive ink of the present invention is dried in box oven or conveyor belt oven by heat convection or infrared. The preferred drying temperature is in the range of 140°C to 200°C, wherein preferred drying time are in the range of 1 min to 10 min.

The dried product exhibits an excellent adhesion to various metallic surfaces, such as aluminum, and a low electrical resistance. In addition the dried product can be soldered to further metallic substrates thereby forming a stable and reliable electrical interconnection.

Therefore, the dried product of the electrically conductive ink is a further aspect of the present invention.

The present invention further provides a bonded assembly, comprising a first substrate and a second substrate which are electrically connected, wherein the first substrate exhibits one or more electrically conductive pathways on its surface, which are formed by the dried product of the electrically conductive ink of the present invention and said one or more electrically conductive pathways are attached to the second substrate by a soldering material thereby forming an electrically conductive connection between the first and the second substrate.

Due to the robust bonding of the dried product to aluminum surfaces and its direct solderability, the electrically conductive ink of the present invention can be used to form one or more electrically conductive pathways on various aluminum or aluminum-containing surfaces, wherein said pathway can be soldered directly to further metallic substrates. These unique properties can be used in the fabrication of solar cell modules. Here, the electrically conductive ink of the present invention is applied to the rear aluminum surface of c-Si solar cells. After being dried the resulting electrically conductive pathways or busbars are directly soldered to conductive connection straps, such as Sn alloy ribbons.

Therefore, another aspect of the present invention is a solar module, comprising the dried product of the electrically conductive ink of the present invention.

An additional aspect of the present invention relates to a method of forming an electrically conductive pathway on a substrate, comprising the steps of
a) providing the electrically conductive ink of the present invention;
b) applying the electrically conductive ink to at least one part of a substrate; and
c) exposing the substrate to a temperature of 70°C to 300°C to form an electrically conductive pathway on at least one part of the substrate.

A further aspect of the present invention relates to a method of forming a bonded assembly, comprising the steps of:
a) providing the electrically conductive ink of the present invention;
b) applying the electrically conductive ink to at least one part of a first metallic substrate;
c) exposing the first metallic substrate to a temperature of 70°C to 300°C to form an electrically conductive pathway on at least one part of the first substrate;
d) soldering a second metallic substrate to the electrically conductive pathway to thereby forming an electrically conductive connection between the first and the second substrate.

As mentioned above, the electrically conductive ink of the present invention can be used in the fabrication of electronic devices, such as solar modules, built up from cells with an Al structure on the back (full Al back surface field, full Al emitter, Al containing electrodes,...).

In this context the invention also relates to the use of the electrically conductive ink of the present invention in the fabrication of electronic devices, such as solar modules, built up from cells with an Al structure on the back. The invention further relates to the use of said ink to form an electrically conductive pathway on a substrate, which comprises or essentially consists of aluminum. Preferred substrates include the Al containing rear surface of c-Si solar cells.

### Examples

The examples described hereunder exemplify the properties of the compositions according to the embodiments of the present invention. Unless otherwise indicated, all parts and percentages in following examples, as well as through out the description, are parts by weight or percentages by weight respectively.

The following examples are included for purposes of illustration so that the disclosure may be more readily understood and are in no way to be intended to limit the scope of the disclosure unless otherwise specifically indicated.

| Raw material | Example 1 | Example 2 | Example 3 | Example 4 |
|---|---|---|---|---|
| Phenoxy resin (PKHH) | 10.184 | 9.005 | 11.761 | 3.870 |
| Phenolic resin in solvent (PF 9132 KP) | 0.359 | | | |
| Polyurethane aromatic (ESTANE 5703) | | | | 5.810 |
| Carbitol Acetate | 28.138 | 24.932 | 31.833 | 32.080 |
| Ag flake (GA238-11) | 61.319 | | | |
| Ag powder (C-2462P) | | 66.062 | | |
| Ag powder (D-2466P) | | | 56.406 | 58.240 |
| Peel result, Newton SnPb ribbon of 2mm width @90° peeling angle | 3.0 on PVD Al | 1.8 on fired Al | 2.3 on fired Al | 2.0 on fired Al |
| | 0.9 on fired Al | | | |

Phenoxy resin PKHH supplied by InChem; Phenolic resin in solvent PF9132KP supplied by Momentive; Polyurethane aromatic ESTANE 5703 supplied by Lubrizol; Ag flake GA238-11 supplied by Metalor; Ag powder D-2466P supplied by Metalor; Ag powder C-2462P supplied by Metalor;

General formula which is used in the examples A-D below:

| | Filler loading | | |
|---|---|---|---|
| | *Low* | *Standard* | *High* |
| Resin : Polymer resin or resin blend, with or without additive resins | 9.66 | 9.33 | 9.01 |
| Carbitol acetate | 33.93 | 28.96 | 24.93 |
| Fillers | 56.41 | 61.71 | 66.06 |
| Pigment to binder ratio, i.e. filler to resin ratio | 5.84 | 6.61 | 7.33 |
| **Filler wt% in dry film -** filler weight % after solvent is removed | 82.75% | 85.76% | 88.0% |

### Example A

Samples were prepared according to general formula above and Phenoxy resin, PKHH (Inchem), was used as standard resin in the examples below and carbitol acetate was used as solvent. Filler was added at same standard loading (Ag%=85.76% in dry film) to all samples. TD is tap density, SSA is specific surface area and D10-D50-D90 are particle sizes of the filler.

Peel strength is measured according to following procedure:
a) a printable solderable ink is applied onto cell backside BSF Al
b) the ink is dried for 6min at 190 °C in a box oven
c) ribbon fluxing: ribbon is placed into fluxing agent, i.e. X33-08I (Henkel), for several minutes; subsequently take them out and dried up in heated air flow
d) soldering process : soldering is manually done in secs/busbar by using heated solder head with working temperature of 360 °C
e) the soldered unit is placed on tester holder and the peel strength is recorded

Peel strength measurement is done with tester model TR1000 supplied by Chemlnstruments. Peel strength tests are done in Adhesion/Release mode with peel angle of 90° and speed of 15 cm/min. Strength unit is Newton. The whole testing is similar with what's described in ASTM D6862-11, with the rigid adherend being fired Al and flexible adherend being SnPb ribbon in this case.

| **Filler type** | **Sample No** | **Filler name (Vendor)** | **Specifications: TD, SSA, D10-D50-D90** | **Peel strength, 2mm ribbon at 90°** |
|---|---|---|---|---|
| Ag flakes | **A1** | GA23811 | 4.0, 0.45, | 3.0N at PVD Al |
| | | (Metalor) | 3.0-10-20 | 0.9N at fired Al |
| | **A2** | AA-192N | 4.0, 0.65, | 2.7N at PVD Al |
| | | (Metalor) | 2.4-8.7-17.9 | 0.8N at fired Al |
| | **A3** | AA-9829 | 5.2, 0.15, | 2.0N at PVD Al |
| | | (Metalor) | 4.1-10.1-21.8 | |
| | **A4** | LA-0113 | 4.7, 0.88, | 2.3N at PVD Al |
| | | (Metalor) | 0.9-2.4-6.8 | |
| | **A5** | FA-SAB-239 | 4.0, 1.18, | 2.4N at PVD Al |
| | | (Dowa) | 2.9-6.6-15.7 | |
| Ag powders | **A6** | C-2462P | 4.1, 0.65, | 2.1N at PVD Al |
| | | (Metalor) | 1.1-2.0-3.6 | 1.5N at fired Al |
| | **A7** | D-2466P | 5.1, 0.35, | 1.8N at fired Al |
| | | (Metalor) | 1.9-4.0-7.6 | |
| | **A8** | D-24617P | 4.8, 0.30, | 1.9N at fired Al |
| | | (Metalor) | 2.0-3.9-7.1 | |
| | **A9** | PV-1 | 4.2, 0.38, | 1.7N at fired Al |
| | | (Ames Goldsmith) | 1.3-3.6-7.5 | |
| | **A10** | PV-2 | 4.7, 0.47, | 2.3N at fired Al |
| | | (Ames Goldsmith) | 0.8-2.2-4.2 | |
| | **A11** | PV-3 | 4.4, 0.95, | 1.3N at fired Al |
| | | (Ames Goldsmith) | 0.8-2.0-3.5 | |
| | **A12** | PV-7 | 5.0, 0.55, | 1.5N at fired Al |
| | | (Ames Goldsmith) | 0.8-2.2-3.9 | |
| Ag coated copper | **A13** | AgCu0305 | 4.3, 0.49, | 2.2N at PVD Al |
| | | (Ferro) | 1.7-3.3-6.1 | 1.2N at fired Al |
| | **A14** | AgCu0810 | 2.9, 0.57, | 1.3N at PVD Al |
| | | (Ferro) | 3.5-9.0-20.5 | |
| | **A15** | NZS-615 | 3.0, 0.93, | 0.8N at PVD Al |
| | | (Ames Goldsmith) | 2.7-6.2-13 | |

| | | | | |
|---|---|---|---|---|
| PVD Al: Al formed by physical vapor deposition on cell back. Fired Al: Al formed by firing Al paste on cell back | | | | |

### Example B

Samples were prepared according to the general formula above, Ag processed powder D-2466P (Metalor) was used as a filler in all runs and carbitol acetate was used as a solvent in all samples. Resin type was varied and specific resins are listed in the table below. The filler was added at same low loading (Ag%=82.75% in dry film) to all samples.

| **Resin type** | **Sample No** | **Peel strength Newton for 2mm ribbon at 90°** |
|---|---|---|
| Phenoxy PKHH (InChem) | **B1** | 2.3N at fired Al |

| *TPU (Aromatic)* | | |
|---|---|---|
| ESTANE 5703 (Lubrizol) | **B2** | 2.2N at fired Al |
| ESTANE 5715 (Lubrizol) | **B3** | 1.7N at fired Al |

| *TPU (Aliphatic)* | | |
|---|---|---|
| IROSTIC 8743 (Huntsman) | **B4** | 0.15N at fired Al |

| *Polyester (Aromatic)* | | |
|---|---|---|
| Vitel 2200B (Bostik) | **B5** | 2.1N at fired Al |
| Vitel 2700B (Bostik) | **B6** | 2.7 at fired Al |
| Vitel 3300B (Bostik) | **B7** | 2.7 at fired Al |

| *Poly (meth)acrylate* | | |
|---|---|---|
| PARALOID A-11 (Dow) | **B8** | 0.3N at fired Al |

| *Vinylidene resin* | | |
|---|---|---|
| SARAN F-310 (Dow) | **B9** | 0.8N at fired Al |

| *Vinyl resin* | | |
|---|---|---|
| SOLBIN A (Nissin) | **B10** | 0.3N at fired Al |
| PVB BUTVAR B-76 (Solutia) | **B11** | 0.6N at fired Al |
| PEI Ultem1010 (GE) | **B12** | 0.4N at fired Al |
| Nitrocellulose NC E 560 (Bayer) | **B13** | <0.1N at fired Al |
| PPO M25904 (Henkel) | **B14** | <0.1N at fired Al |
| Fluorine resin FC2178 (3M) | **B15** | <0.1N at fired Al |

| | | |
|---|---|---|
| Fired Al: Al formed by firing Al paste on cell back | | |

### Example C

Samples were prepared according to the general formula above and Phenoxy resin, PKHH (Inchem), was used as standard resin in the runs below and carbitol acetate was used as solvent. Filler was added at same standard loading (Ag%=85.76% in dry film) to all samples. Different particle sizes were used categorized as small, medium and large for both filler powders and filler flakes. TD is tap density, SSA is specific surface area and D10-D50-D90 are particle sizes of the filler. Peel strength is tested on fired Al.

| **Particle type / Particle size** | **Sample No** | **TD, SSA, D10-D50-D90** | **Average peel strength, 2mm ribbon** at **90°, Newton** |
|---|---|---|---|
| Powder / small | **C1** | AG-SAB-321 (Dowa) | 0.16N |
| | | 4.3, 1.62, | |
| | | 0.3-0.6-1.4 | |
| | **C2** | K-1322P (Metalor) | 1.12N |
| | | 4.2, 2.02 | |
| | | 0.6-1.26-2.32 | |
| | **C3** | C-0083P (Metalor) | 0.55N |
| | | 1.4, 1.54 | |
| | | 0.5-1.4-3.0 | |
| Powder / medium | **C4** | C-2462P (Metalor) | 1.11N |
| | | 4.1, 0.65 | |
| | | 1.1-2.0-3.6 | |
| | **C5** | PV-2 (Ames Goldsmith) | 1.22N |
| | | 4.7, 0.47 | |
| | | 0.8-2.2-4.2 | |
| | **C6** | PV-1 (Ames Goldsmith) | 1.69N |
| | | 4.2, 0.38 | |
| | | 1.3-3.6-7.5 | |
| | **C7** | D-2466P (Metalor) | 1.72N |
| | | 5.1, 0.35 | |
| | | 1.9-4.0-7.6 | |
| Powder / Large | **C8** | D-3016P (Metalor) | 1.67N |
| | | 5.1, 0.3 | |
| | | 2.3-5.2-10.5 | |
| Flake / small | **C9** | SF 77A (Ferro) | 0.78N |
| | | 3.6, 2.0 | |
| | | 0.4-1.0-2.7 | |
| | **C10** | FA-SAB-284 (Dowa) | 0.75N |
| | | 5.3, 0.85 | |
| | | 1.1-2.2-3.9 | |
| | **C11** | SF-120 (Ferro) | 1.24N |
| | | 5.0, 0.8 | |
| | | 1.5-3.0-5.5 | |
| Flake / medium | **C12** | EA-0295 (Metalor) | 1.22N |
| | | 4.4, 0.53 | |
| | | 1.5-5.2-13.3 | |
| | **C13** | AA-192N (Metalor) | 0.85N |
| | | 4.0, 0.65 | |
| | | 2.4-8.7-17.9 | |
| | **C14** | GA23811 (Metalor) | 1.14N |
| | | 4.0, 0.45 | |
| | | 3.0-10-20 | |
| Flake / large | **C15** | KP-84 (Ames Goldsmith) | 0.07N |
| | | 1.0, 1.8 | |
| | | 6.0-12-20 | |

Elemental analysis was done for the area of interest: dry ink cross section area from underneath the SnPb/ink interface till half depth of dry ink layer. A Horiba EDX set was attached to section scanning electron microscope S-3400N to provide elemental analysis of designated area of interest. Processing option was all elements analyzed (Normalised).

Elemental analysis of C1:
C (K) Weight % 27.57 -Atomic % 58.43 : O (K) Weight % 18.17 -Atomic % 28.92: Ag (L) Weight % 47.13 ― Atomic % 11.12: Sn (L) Weight % 7.12 - Atomic % 1.53.

Elemental analysis of C7:
C (K) Weight % 16.76 ― Atomic % 57.77 : O (K) Weight % 6.30 - Atomic % 16.31: Ag (L) Weight % 32.86 ― Atomic % 12.61: Sn (L) Weight % 30.24 ― Atomic % 10.55 : Pb (M) weight % 13.84 ― Atomic 2.77.

Elemental analysis of C11:
C (K) Weight % 9.11 - Atomic % 38.86 : O (K) Weight % 7.74 - Atomic % 24.80: Ag (L) Weight % 45.88 - Atomic % 21.79: Sn (L) Weight % 28.88 - Atomic % 12.47 : Pb (M) weight % 8.39 - Atomic 2.08.

Elemental analysis of C15:
C (K) Weight % 9.17 - Atomic % 46.18 : O (K) Weight % 2.36 - Atomic % 8.91: Ag (L) Weight % 53.16 ― Atomic % 29.81: Sn (L) Weight % 22.03 ― Atomic % 11.23 : Pb (M) weight % 13.29 ― Atomic 3.88.

### Example D

Samples were prepared according to the general formula above and aromatic, non-aromatic and resin blends were varied as specified in the table below, carbitol acetate was used as solvent. AG processed powder D-2466P (Metalor) was used as a filler in all samples. Filler was added at same low loading (Ag%=82.75% in dry film) to all samples. Peel strength is tested on fired Al.

| **Resin type** | **Sample** No | **Resin** | **Average peel strength, 2mm ribbon at 90°, Newton** |
|---|---|---|---|
| Aromatic | **D1** | PKHH (InChem) | 2.01N |
| | **D2** | PKCP-80 (InChem) | 2.35N |
| | **D3** | ESTANE 5715 (Lubrizol) | 1,71N |
| | **D4** | Vitel 2700B (Bostik) | 3.05N |
| Non-aromatic | **D5** | PARALOID A-11 (Dow) | 0.45N |
| | **D6** | SARAN F-310 (Dow) | 0.65N |
| | **D7** | NC E 560 (Bayer) | 0.03N |
| | **D8** | Ultem1010 (GE) | 0.37N |
| Resin blend | **D9** | PKHH / ESTANE5703 | 2.0 ― 2.8 N |

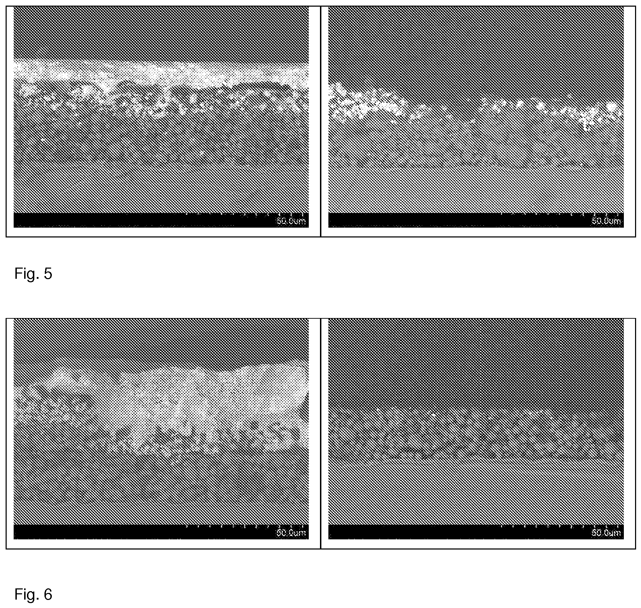

Example D shows that aromatic resins provide excellent adhesion especially on fired aluminium, which is essential factor for a good peel. Non-aromatics provide weak adhesion and hence, the peel strength is low. This is also shown in figures 5 and 6.

Elemental analysis was done for the area of interest: fired Al cross section area from underneath the ink/AI interface till half depth of fired Al layer. A Horiba EDX set was attached to section scanning electron microscope S-3400N to provide elemental analysis of designated area of interest. Processing option was all elements analyzed (Normalised).

Elemental analysis of D1:
C (K) Weight % 40.88 ― Atomic % 58.23 : O (K) Weight % 10.47 ― Atomic % 11.19: Al (K) Weight % 37.74 - Atomic % 23.93: Si (K) Weight % 10.91 - Atomic % 6.65.

Elemental analysis of D5:
C (K) Weight % 43.80 - Atomic % 60.30 : O (K) Weight % 12.91 - Atomic % 13.34: Al (K) Weight % 35.77 - Atomic % 21.92: Si (K) Weight % 7.53 - Atomic % 4.43.

Elemental analysis of fired Al without ink applied on top (blank):
C (K) Weight % 2.70 - Atomic % 5.53 : O (K) Weight % 9.96 - Atomic % 15.32: Al (K) Weight % 72.84- Atomic % 66.44: Si (K) Weight % 14.50 - Atomic % 12.71.

A good penetration of SnPb into ink layer is visualized in figures 5 and 6. This together with comparison to blank EDX analyses showed that both resins had good penetration into Al layer. However, aromatic resin of D1 resulted in very good peel strength (average 2.0N) and cohesive failure mode, while non-aromatic resin of D5 ended up with poor peel strength (average 0.45N) and peeling failure at ink/AI interface.

## Claims

1. An electrically conductive ink, comprising
a) from 8 to 12 wt% based on the total amount of the electrically conductive ink of one or more aromatic resins;
b) from 52 to 68 wt% based on the total amount of the electrically conductive ink of electrically conductive silver particles, wherein the electrically conductive silver particles have a silver content of at least 95 wt.-%, based on the total amount of the electrically conductive silver particles, having an average particle size of 2 µm to 20 µm, wherein D₅₀ value is measured through laser diffractometry, and a tap density of 2.5 g/cm³ to 6.0 g/cm³, wherein the tap density is determined in accordance to ISO 3953 typically using a 25 cm³ graduated glass cylinder; and
c) from 15 to 35 wt% based on the total amount of the electrically conductive ink of one or more organic solvents,
when the electrically conductive ink only comprises aromatic resins and no further non-aromatic resins.

2. The electrically conductive ink according to claim 1, wherein the aromatic resin is selected from the group consisting of phenoxy resins, aromatic polyester resins, aromatic thermoplastic polyurethanes, and any combination thereof.

3. The electrically conductive ink according to claim 1 or 2, wherein the aromatic resin is a phenoxy resin.

4. The electrically conductive ink according to any preceding claim, wherein the electrically conductive silver particles have a specific surface area of 0.1 m²/g to 1.6 m²/g.

5. The electrically conductive ink according to any preceding claim, wherein the organic solvent is selected from esters, ethers, ether-esters, ketones or combinations thereof, preferably the organic solvent is a glycol ether acetate.

6. The dried product of the electrically conductive ink according to any one of Claims 1 to 5.

7. A bonded assembly, comprising a first substrate and a second substrate which are electrically connected, wherein the first substrate exhibits one or more electrically conductive pathways on its surface, which are formed by the dried product of Claim 6 and said one or more electrically conductive pathways are attached to the second substrate by a soldering material thereby forming an electrically conductive connection between the first and the second substrate, wherein the first substrate preferably comprises or essentially consists of aluminum.

8. A solar module, comprising the bonded assembly of claim 6 or 7.

9. A method of forming an electrically conductive pathway on a substrate, comprising the steps of
a) providing the electrically conductive ink according to any one of claims 1 to 5;
b) applying the electrically conductive ink to at least one part of a substrate; and
c) exposing the substrate to a temperature of 70°C to 300°C to form an electrically conductive pathway on at least one part of the substrate.

10. A method of forming a bonded assembly, comprising the steps of:
a) providing the electrically conductive ink according to any one of claims 1 to 5;
b) applying the electrically conductive ink to at least one part of a first metallic substrate;
c) exposing the first metallic substrate to a temperature of 70°C to 300°C to form an electrically conductive pathway on at least one part of the first substrate;
d) soldering a second metallic substrate to the electrically conductive pathway to thereby forming an electrically conductive connection between the first and the second substrate.

11. Use of the electrically conductive ink according to any one of claims 1 to 5 to form an electrically conductive pathway on a substrate, which comprises or essentially consists of aluminum.

12. Use of the electrically conductive ink according to any one of claims 1 to 5 in the fabrication of electronic devices.

## Patentansprüche

1. Elektrisch leitfähige Tinte, umfassend
a) von 8 bis 12 Gew.-%, basierend auf der Gesamtmenge der elektrisch leitfähigen Tinte, eines oder mehrerer aromatischer Harze;
b) von 52 bis 68 Gew.-%, basierend auf der Gesamtmenge der elektrisch leitfähigen Tinte, elektrisch leitfähiger Silberpartikel, wobei die elektrisch leitfähigen Silberpartikel einen Silbergehalt von mindestens 95 Gew.-%, basierend auf der Gesamtmenge der elektrisch leitfähigen Silberpartikel, aufweisen, die eine durchschnittliche Partikelgröße von 2 µm bis 20 µm, wobei ein D₅₀-Wert durch Laserdiffraktometrie gemessen wird, und eine Klopfdichte von 2,5 g/cm³ bis 6,0 g/cm ³ aufweisen, wobei die Klopfdichte gemäß ISO 3953, typischerweise unter Verwendung eines gläsernen Messzylinders mit 25 cm³, bestimmt wird; und
c) von 15 bis 35 Gew.-%, basierend auf der Gesamtmenge der elektrisch leitfähigen Tinte, eines oder mehrerer organischer Lösungsmittel,
wenn die elektrisch leitfähige Tinte nur aromatische Harze und keine weiteren nichtaromatischen Harze umfasst.

2. Elektrisch leitfähige Tinte nach Anspruch 1, wobei das aromatische Harz aus der Gruppe ausgewählt ist, die aus Phenoxyharzen, aromatischen Polyesterharzen, aromatischen Thermoplastpolyurethanen und einer beliebigen Kombination davon besteht.

3. Elektrisch leitfähige Tinte nach Anspruch 1 oder 2, wobei das aromatische Harz ein Phenoxyharz ist.

4. Elektrisch leitfähige Tinte nach einem der vorhergehenden Ansprüche, wobei die elektrisch leitfähigen Silberpartikel eine spezifische Oberfläche von 0,1 m²/g bis 1,6 m²/g aufweisen.

5. Elektrisch leitfähige Tinte nach einem der vorhergehenden Ansprüche, wobei das organische Lösungsmittel aus Estern, Ethern, Etherestern, Ketonen oder Kombinationen davon ausgewählt ist, wobei vorzugsweise das organische Lösungsmittel ein Glykoletherazetat ist.

6. Getrocknetes Produkt der elektrisch leitfähigen Tinte nach einem der Ansprüche 1 bis 5.

7. Gebondete Anordnung, umfassend ein erstes Substrat und ein zweites Substrat, die elektrisch verbunden sind, wobei das erste Substrat einen oder mehrere elektrisch leitfähige Pfade auf seiner Oberfläche vorweist, die durch das getrocknete Produkt nach Anspruch 6 ausgebildet sind, und der eine oder die mehreren elektrisch leitfähigen Pfade an dem zweiten Substrat durch ein Lötmaterial angebracht sind, wobei dadurch eine elektrisch leitfähige Verbindung zwischen dem ersten und dem zweiten Substrat ausgebildet wird, wobei das erste Substrat vorzugsweise Aluminium umfasst oder im Wesentlichen aus diesem besteht.

8. Solarmodul, umfassend die gebondete Anordnung nach Anspruch 6 oder 7.

9. Verfahren zum Ausbilden eines elektrisch leitfähigen Pfads auf einem Substrat, umfassend die Schritte:
a) Bereitstellen der elektrisch leitfähigen Tinte gemäß einem der Ansprüche 1 bis 5;
b) Aufbringen der elektrisch leitfähigen Tinte auf mindestens einen Teil eines Substrats; und
c) Aussetzen des Substrats an eine Temperatur von 70 °C bis 300 °C, um einen elektrisch leitfähigen Pfad auf mindestens einem Teil des Substrats auszubilden.

10. Verfahren zum Ausbilden einer gebondeten Anordnung, umfassend die Schritte:
a) Bereitstellen der elektrisch leitfähigen Tinte gemäß einem der Ansprüche 1 bis 5;
b) Aufbringen der elektrisch leitfähigen Tinte auf mindestens einen Teil eines ersten metallischen Substrats;
c) Aussetzen des ersten metallischen Substrats an eine Temperatur von 70 °C bis 300 °C, um einen elektrisch leitfähigen Pfad auf mindestens einem Teil des ersten Substrats auszubilden;
d) Löten eines zweiten metallischen Substrats an den elektrisch leitfähigen Pfad, um dadurch eine elektrisch leitfähige Verbindung zwischen dem ersten und dem zweiten Substrat auszubilden.

11. Verwendung der elektrisch leitfähigen Tinte nach einem der Ansprüche 1 bis 5, um einen elektrisch leitfähigen Pfad auf einem Substrat auszubilden, das Aluminium umfasst oder im Wesentlichen aus diesem besteht.

12. Verwendung der elektrisch leitfähigen Tinte nach einem der Ansprüche 1 bis 5 bei der Herstellung elektronischer Vorrichtungen.

## Revendications

1. Encre électriquement conductrice, comprenant
a) de 8 à 12 % en poids sur la base de la quantité totale d'encre électriquement conductrice d'une ou de plusieurs résines aromatiques ;
b) de 52 à 68 % en poids sur la base de la quantité totale de l'encre électriquement conductrice de particules d'argent électriquement conductrices, les particules d'argent électriquement conductrices ayant une teneur en argent d'au moins 95 % en poids, sur la base de la quantité totale de l'électricité conductrice des particules d'argent, ayant une granulométrie moyenne de 2 µm à 20 µm, la valeur de D₅₀ étant mesurée par diffractométrie laser, et une masse volumique tassée de 2,5 g/cm³ à 6,0 g/cm³, la masse volumique tassée étant déterminée conformément à la norme ISO 3953 utilisant généralement un cylindre de verre gradué de 25 cm³ ; et
c) de 15 à 35 % en poids sur la base de la quantité totale d'encre électriquement conductrice d'un ou de plusieurs solvants organiques,
lorsque l'encre électriquement conductrice ne comprend que des résines aromatiques et aucune autre résine non-aromatique.

2. Encre électriquement conductrice selon la revendication 1, la résine aromatique étant choisie dans le groupe constitué par les résines phénoxy, les résines polyester aromatiques, les polyuréthanes thermoplastiques aromatiques et toute combinaison de celles-ci.

3. Encre électriquement conductrice selon la revendication 1 ou 2, la résine aromatique étant une résine phénoxy.

4. Encre électriquement conductrice selon l'une quelconque des revendications précédentes, les particules d'argent électriquement conductrices ayant une surface spécifique de 0,1 m²/g à 1,6 m²/g.

5. Encre électriquement conductrice selon l'une quelconque des revendications précédentes, le solvant organique étant choisi parmi les esters, les éthers, les éther-esters, les cétones ou leurs combinaisons, de préférence le solvant organique étant un éther acétate de glycol.

6. Produit séché de l'encre électriquement conductrice selon l'une quelconque des revendications 1 à 5.

7. Ensemble lié, comprenant un premier substrat et un second substrat qui sont connectés électriquement, le premier substrat présentant sur sa surface une ou plusieurs voies électriquement conductrices, lesquelles sont formées par le produit séché selon la revendication 6 et ladite une ou plusieurs voies conductrices sont fixées au second substrat par un matériau de soudage, formant ainsi une connexion électriquement conductrice entre le premier et le second substrat, le premier substrat comprenant de préférence ou étant constitué essentiellement d'aluminium.

8. Module solaire, comprenant l'ensemble collé selon la revendication 6 ou 7.

9. Procédé de formation d'une voie électriquement conductrice sur un substrat, comprenant les étapes consistant à
a) fournir l'encre électriquement conductrice selon l'une quelconque des revendications 1 à 5 ;
b) appliquer l'encre électriquement conductrice sur au moins une partie d'un substrat ; et
c) exposer le substrat à une température de 70 °C à 300 °C pour former une voie électriquement conductrice sur au moins une partie du substrat.

10. Procédé de formation d'un article collé, comprenant les étapes consistant à :
a) fournir l'encre électriquement conductrice selon l'une quelconque des revendications 1 à 5 ;
b) appliquer l'encre électriquement conductrice sur au moins une partie d'un premier substrat métallique ;
c) exposer le premier substrat métallique à une température de 70 °C à 300 °C pour former une voie électriquement conductrice sur au moins une partie du premier substrat ;
d) souder un second substrat métallique sur la voie électriquement conductrice pour former ainsi une connexion électriquement conductrice entre le premier et le second substrat.

11. Utilisation de l'encre électriquement conductrice selon l'une quelconque des revendications 1 à 5 pour former une voie électriquement conductrice sur un substrat, qui comprend ou est essentiellement constitué d'aluminium.

12. Utilisation de l'encre électriquement conductrice selon l'une quelconque des revendications 1 à 5 dans la fabrication de dispositifs électroniques.
